# EUROPÄISCHE PATENTSCHRIFT

(11) **EP 3 224 385 B1**
(45) Veröffentlichungstag und Bekanntmachung des Hinweises auf die Patenterteilung: **24.10.2018**
(21) Anmeldenummer: 15800760.9
(22) Anmeldetag: 19.11.2015
(51) Int. Cl.: C23C 14/12, C23C 14/24, C23C 14/56, C23C 16/455

(54) **VORRICHTUNG ZUM ABSCHEIDEN EINER SCHICHT AUF EINEM SUBSTRAT**
DEVICE FOR DEPOSITING A LAYER ON A SUBSTRATE
DISPOSITIF POUR DÉPOSER UNE COUCHE SUR UN SUBSTRAT

(30) Priorität: 28.11.2014 DE 102014117492
(43) Veröffentlichungstag der Anmeldung: 04.10.2017
(73) Patentinhaber: Aixtron SE, 52134 Herzogenrath (DE)
(72) Erfinder: LONG, Michael, 52134 Herzogenrath (DE)
(74) Vertreter: Grundmann, Dirk
(86) Internationale Anmeldenummer: PCT/EP2015/077113
(87) Internationale Veröffentlichungsnummer: WO 2016/083238

(56) Entgegenhaltungen:
- WO-A1-2012/051485
- WO-A1-2012/175126
- US-A1- 2012 237 695
- US-A1- 2013 001 330

## Beschreibung

Die Erfindung betrifft eine Vorrichtung zum Abscheiden einer Schicht auf einem Substrat, das beim Beschichten quer zur Erstreckungsrichtung eines Gaseinlassorgans in einer Prozesskammer in einer Bewegungsrichtung bewegt wird, wobei das Gaseinlassorgan eine erste Gasverteilkammer aufweist mit einer Einspeiseöffnung zum Einspeisen eines Ausgangsstoffs und einer sich über die gesamte Breite der Bewegungsbahn des Substrates erstreckenden, zum Substrat weisenden ersten Gasaustrittszone zum Austritt eines ersten Gasstroms, das den Ausgangsstoff beinhaltet, wobei parallel zur Erstreckungsrichtung der ersten Gasaustrittszone in Bewegungsrichtung des Substrates vor der ersten Gasaustrittszone eine zweite Gasaustrittszone und in Bewegungsrichtung des Substrates nach der ersten Gasaustrittszone eine dritte Gasaustrittszone, jeweils einer zweiten beziehungsweise dritten Gasverteilkammer angeordnet sind zum Austritt jeweils eines zweiten beziehungsweise dritten Gasstroms.

Die Erfindung betrifft das technische Gebiet der Abscheidung von Schichten, insbesondere Halbleiterschichten auf einem Substrat. Das technische Gebiet umfasst die Chemical Vapor Deposition und die Physical Vapor Deposition. Bei ersterer findet bei der Abscheidung eines gasförmig in eine Prozesskammer eingebrachten Ausgangsstoffs eine chemische Reaktion statt; bei letzterer findet bei der Abscheidung eines gasförmig in eine Prozesskammer eingebrachten Ausgangsstoffs im Wesentlichen eine Aggregatsänderung statt, indem der gasförmige Ausgangsstoff auf dem Substrat kondensiert. Das Anwendungsgebiet der Erfindung betrifft insbesondere die Organic Vapor Phase Deposition (OVPD). Bei diesem Abscheideverfahren wird ein organischer Ausgangsstoff entweder als Festkörper oder als Flüssigkeit bereitgestellt. Der Ausgangsstoff wird auf eine Verdampfungstemperatur aufgeheizt. Der dabei erzeugte Dampf wird in eine Prozesskammer einer Beschichtungsvorrichtung transportiert. Dies kann mit Hilfe eines Trägergases erfolgen. Das Substrat steht in einem berührenden Kontakt zu einem gekühlten Suszeptor, so dass der in die Dampfform gebrachte organische Ausgangsstoff auf der Oberfläche des Substrates kondensiert. Das technische Gebiet umfasst insbesondere auch die Fertigung von OLEDs.
Eine Vorrichtung der gattungsbildenden Art wird in der US 2012/0237695 A1 beschrieben. Das dort beschriebene "Linear Vapor Deposition System" besitzt ein Gaseinlassorgan mit mehreren sich parallel zueinander erstreckenden, jeweils linienförmigen Gasaustrittszonen, wobei durch eine mittlere Gasaustrittszone der gasförmige Ausgangsstoff und durch davon entfernt angeordnete äußere Gasaustrittszonen ein Inertgas in Richtung auf das Substrat austritt. Das Substrat wird quer zur Erstreckungsrichtung der Gasaustrittszone bewegt.

Die WO 2012/051485 A1 beschreibt ein Gaseinlassorgan mit mehreren Gasverteilerkammern. Die US 5,595,602, US 6,037,241, US 7,238,389 B2, US 7,780,787 B2, WO 2012/175126, WO 2012/175128 sowie WO 2012/175307 beschreiben Gaseinlassorgane an PVD-Einrichtungen, die einen elektrisch aufgeheizten porösen Festkörperschaum verwenden, um die festen oder flüssigen Partikel in einem Aerosol-Fluss durch Übertragung von Verdampfungswärme in die Gasform zu bringen, um den gasförmigen Ausgangsstoff mit Hilfe eine Trägergases aus einer Gasaustrittsöffnung des Gaseinlassorganes hin zu einem Substrat zu transportieren, wo der in die Gasform gebrachte Ausgangsstoff wieder kondensiert.
Anders als bei Gaszuführeirichtungen, bei denen der Zustrom der gasförmigen Ausgangsstoffe zum Substrat mittels Ventile ein- und ausgeschaltet werden kann, bietet die Verwendung eines beheizten Schaumkörpers die Möglichkeit durch Änderung der Temperatur des Schaumkörpers den Materialfluss des Ausgangsstoffs zum Substrat zu beeinflussen. Liegt die Temperatur des Schaumkörpers unterhalb der Verdampfungstemperatur, so findet im Schaumkörper eine Anreicherung des in ihn eingespeisten Aerosols statt. Durch eine Erhöhung der Temperatur des vom Schaumkörper gebildeten Verdampfungskörpers wird die Verdampfungsrate erhöht, so dass sich durch eine Temperatursteuerung der Materialfluss des Ausgangsstoffs zum Substrat einstellen lässt. Die Verwendung von porösen Schaumkörpern als Dampfquelle bringt auch den Vorteil, mehrere voneinander verschiedene Ausgangsstoffe gleichzeitig verdampfen zu können, um mehrere Ausgangsstoffe in die Prozesskammer einzuleiten, beispielsweise um auf verschiedenen Wellenlängen lichtemitierende organische Moleküle auf einem Substrat abzuscheiden. Auch eine Dotierung ist auf diese Weise möglich. Der Dampf tritt im Wesentlichen gleichmäßig über die gesamte Gasaustrittsfläche des Schaumkörpers heraus. Es besteht das Problem, dass der Dampf, der durch die Randabschnitte der Gasaustrittsfläche austritt, zufolge einer niedrigen Gastemperatur des die Gasaustrittsfläche umgebenden Gases kondensiert. Dies kann zu Ausflockungen, also zu einer Partikelbildung, in der Gasphase führen. Letztere beeinflusst nachteilig die Qualität der abgeschiedenen Schicht.

Der Erfindung liegt die Aufgabe zugrunde, eine Vorrichtung zu schaffen, mit der großflächig Substrate mit ein oder mehreren organischen Ausgangsstoffen beschichtet werden kann, wobei mit einem minimalen Materialeinsatz ein hoher Durchsatz erzielt werden soll, ohne dass es zu einer thermischen Zerstörung des Ausgangsstoffes kommt.

Gelöst wird die Aufgabe durch die in den Ansprüchen angegebene Erfindung, wobei jeder Anspruch grundsätzlich eine eigenständige Lösung der Aufgabe darstellt.

Zunächst und im Wesentlichen ist vorgesehen, dass drei oder mehr Gasaustrittszonen unmittelbar benachbart nebeneinander verlaufen. Durch mindestens eine mittlere Gasaustrittszone tritt der gasförmige Ausgangsstoff in die Prozesskammer. Durch die beiden äußeren, die mittlere Gasaustrittszone flankierenden Austrittszonen tritt ein Inertgas in die Prozesskammer ein. Die beiden Inertgasströme beeinflussen den Randbereich des mittleren Gasstroms, so dass der mittlere Gasstrom nicht divergiert. Die beiden äußeren Gasströme bewirken eine Kollimation des den Ausgangsstoff transportierenden mittleren Gasstroms. Die beiden äußeren Gasströme bilden somit Kollimator-Gasströme, die dem mittleren Gasstrom eine lineare Strömungsrichtung aufzwingen. Alle drei Gasströme besitzen eine erhöhte Temperatur, wozu die drei Gasverteilkammern jeweils eine Gasheizeinrichtung aufweisen. In der mittleren Gasverteilkammer findet darüber hinaus eine Verdampfung eines Aerosols statt, welches feste oder flüssige Partikel aufweist. Die Verdampfungseinrichtung der mittleren Gasverteilkammer kann von der dort angeordneten Heizeinrichtung ausgebildet sein. Die Heizeinrichtung beziehungsweise der Verdampfungskörper kann ein elektrisch leitfähiger offenporiger Festkörper sein, wie er im eingangs erörterten Stand der Technik beschrieben wird. Es kann sich um einen Schaumkörper handeln, der die jeweils ihm zugeordnete Gasverteilkammer vollständig ausfüllen kann. Benachbarte Gasverteilkammern sind von einer elektrisch isolierenden Trennwand voneinander getrennt. Die Trennwand kann aus einem keramischen Material bestehen. Eine oder mehrere Prozessgas-Verteilkammern sowie die zweiten und dritten Gasverteilkammern können einem ein Gaseinlassorgan ausbildenden Gehäuse zugeordnet sein. Es handelt sich um ein langgestrecktes Gehäuse, welches sich quer zur Bewegungsrichtung über die gesamte Breite des Substrates erstreckt. Der aus der mindestens einen Prozessgas-Austrittszone heraustretende Prozessgasstrom wird von beheizten Inertgasströmen flankiert, so dass es zu keiner Abkühlung des Randbereichs des Prozessgasstroms kommt. Die oben beschriebenen Ausflockungen in der Gasphase werden verhindert. In dem das Substrat quer zur Erstreckungsrichtung der linienförmig nebeneinanderliegenden Gasaustrittszonen langsam bewegt wird, scheidet sich im Zuge des Durchlaufs des Substrates auf dessen Oberfläche eine Schicht ab, die aus einem Kondensat des aus der mittleren Gasaustrittszone austretenden dampfförmigen Ausgangsstoffs besteht. Hierzu wird das Substrat gekühlt. Es bewegt sich über einen aktiv gekühlten Suszeptor. Anstelle des Substrates kann aber auch das Gaseinlassorgan relativ gegenüber dem Substrat bewegt werden. Die beiden jeweils den Enden der linienförmigen Gasaustrittszonen zugeordneten Seitenflächen des Gaseinlassorgans bilden Stirnseiten. An diesen Stirnseiten besitzen die Heizeinrichtungen, also insbesondere die Schaumkörper, Elektroden, mit Hilfe derer ein elektrischer Strom in den offenporigen Festkörper eingespeist werden kann, so dass die Schaumkörper widerstandsbeheizt sind. Es kann eine Prozessgas-Verteilkammer vorgesehen sein. Es können aber auch zwei oder mehrere Prozessgas-Verteilkammern vorgesehen sein, die unmittelbar nebeneinander angeordnet sind. Die mehreren Prozessgas-Verteilkammern grenzen dann unmittelbar aneinander. Letzteres gilt auch für die jeweiligen Gasaustrittszonen der Prozessgas-Verteilkammern. Die mindestens eine Prozessgas-Verteilkammer kann in eine oder mehrere Abschnitte unterteilt sein. Die Abschnitte können von einer Platte getrennt sein. Die Platte kann Öffnungen aufweisen. Ein stromaufwärtiger Abschnitt ist mit der Gaseintrittsöffnung verbunden. Ein stromabwärtiger Abschnitt ist der Gasaustrittszone zugeordnet. Die Platte beeinflusst die Strömung und bildet eine Strömungsbegrenzungsplatte beziehungsweise eine Diffusorplatte. Die Gaseintrittsöffnung der ersten Gasverteilkammer ist mit einem Aerosolgenerator verbunden. Der Aerosolgenerator kann einen Vorratsbehälter aufweisen, in dem ein Pulver oder eine Flüssigkeit bevorratet wird. Mit Hilfe eines Trägergases wird ein Festkörper- oder Tröpfchen-Aerosol erzeugt, welches mit Hilfe des Trägergases in die Gasverteilkammer eingespeist wird, wo durch eine Temperaturbeaufschlagung des Aerosols eine Verdampfung stattfindet. Wegen der Verwendung eines porösen Festkörpers findet gleichzeitig eine Homogenisierung des Gasstroms statt, so dass die Einspeisung des Aerosols nur an wenigen Stellen stattfinden braucht. Die Verdampfung findet bevorzugt nur im stromaufwärtigen Abschnitt statt. Der dortige offenporige Festkörper liefert eine ausreichende Wärme, um das dort eingespeiste Aerosol zu verdampfen. Der Dampf tritt durch eine Trennzone, beispielsweise durch die Öffnungen der Strömungsbeeinflussungsplatte oder Trennplatte, in den stromabwärtigen Abschnitt ein. Dieser kann durch Einleiten eines gekühlten Gases aktiv gekühlt werden, so dass dort bei Bedarf eine Kondensation des Ausgangsstoffs stattfindet. Hierdurch wird verhindert, dass der gasförmige Ausgangsstoff aus der Gasaustrittszone austritt, wenn er dort nicht benötigt wird. Soll hingegen der gasförmige Ausgangsstoff aus der Gasaustrittsöffnung austreten, so wird der stromabwärtige Abschnitt nicht gekühlt. Der dortige Schaumkörper besitzt dann eine Temperatur, die oberhalb der Verdampfungstemperatur des Ausgangsstoffs liegt, so dass der im stromaufwärtigen Abschnitt verdampfte Ausgangsstoff ungehindert den stromabwärtigen Abschnitt der Prozessgas-Verteilkammer beziehungsweise den darin angeordneten Schaumkörper durchströmen kann. Mit dem im stromabwärtigen Abschnitt der Prozessgas-Verteilkammer angeordneten Schaumkörper lässt sich somit die Zuführung des Ausgangsstoffs in die Prozesskammer ein- und ausschalten, wobei im ausgeschalteten Zustand aber kein Verlust entsteht, da der Ausgangsstoff im stromabwärtigen Abschnitt der Gasverteilkammer beziehungsweise im dort angeordneten Schaumkörper zwischengespeichert wird. Er verdampft dort nach einer entsprechenden Aufheizung. Die Trennzone zwischen einem stromaufwärtigen Abschnitt und einem stromabwärtigen Abschnitt der Prozessgas-Verteilkammer braucht keine Diffusorplatte oder dergleichen aufzuweisen. Es ist auch möglich, dass im Bereich der Trennzone lediglich die Grenze zweier Gasheizeinrichtungen verläuft. Eine stromabwärtige Gasheizeinrichtung, welche die Gasaustrittsfläche ausbildet, ist auf eine Temperatur temperierbar, bei der der Dampf innerhalb der Gasheizeinrichtung kondensiert. Es reicht aus, wenn sich dieser, kühlbare Bereich der Prozessgas-Verteilkammer auf einen Bereich unmittelbar stromaufwärts der Gasaustrittsfläche beschränkt. Zwischen den beiden äußeren Gasaustrittszonen können auch mehrere Prozessgas-Austrittszonen für verschiedene Ausgangsstoffe angeordnet sein. Diese mehreren Gasaustrittszonen grenzen bevorzugt direkt aneinander.

Durch die Hintereinanderanordnung mehrerer, jeweils das Substrat überbrückender Gaseinlassorgane können voneinander verschiedene organische Ausgangsstoffe übereinander abgeschieden werden, während das Substrat relativ zu den ein oder mehreren Gasaustrittsorganen bewegt wird. Es lassen sich mehr als drei voneinander verschiedene Ausgangsstoffe jeweils mit Hilfe eines einzelnen linienförmigen Gaseinlassorganes in die Prozesskammer bringen, wobei der den gasförmigen Ausgangsstoff transportierende Gasstrom jeweils von zwei Hilfsgasvorhängen flankiert ist. Das Hilfsgas ist bevorzugt Stickstoff. Diese Gasvorhangflüsse haben zwei Funktionen. Sie isolieren den mittleren Dampffluss von einer thermischen Variation. Indem die Vorhang-Gasströme ebenfalls beheizt sind, behält der den Ausgangsstoff transportierende Gasstrom ein homogenes Temperaturprofil. Die Randbereiche dieses mittleren Gasstroms haben dieselbe Temperatur wie der Kernbereich. Es findet somit keine Kondensation innerhalb des Strömungsweges von der Gasaustrittszone zum Substrat statt. Die Kondensation findet erst auf der Substratoberfläche statt. Die zweite Funktion der Vorhang-Gasströme ist die oben bereits erörterte kollimierende Funktion. Ein weiterer Vorteil der erfindungsgemäßen Ausgestaltung eines Gaseinlassorganes ist die Unterdrückung einer Kreuzkontamination mit anderen gasförmigen Ausgangsstoffen. Es wird auch wirksam verhindert, dass eine Kondensation des gasförmigen Ausgangsstoffes an anderen Stellen innerhalb der Prozesskammer stattfindet, außer auf der Oberfläche des Substrates.

Ausführungsbeispiele der Erfindung werden nachfolgend anhand beigefügter Zeichnungen erläutert. Es zeigen:

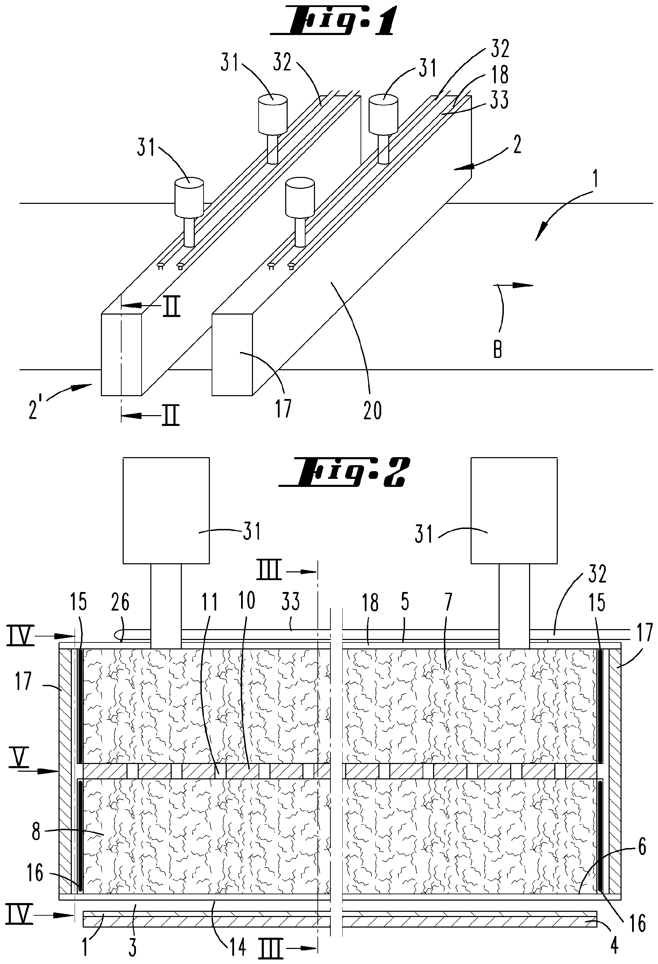

- Fig. 1: eine perspektivische Darstellung zweier parallel zueinander angeordneten linienförmigen Gaseinlassorgane 2, 2', die ein längliches Substrat 1 kreuzen,
- Fig. 2: einen Schnitt gemäß der Linie II-II durch das Gaseinlassorgan,
- Fig. 3: den Schnitt gemäß der Linie III-III in Figur 2,
- Fig. 4: den Schnitt gemäß der Linie IV-IV in Figur 2,
- Fig. 5: eine Stirnseitenansicht entsprechend des Pfeiles V in Figur 2,

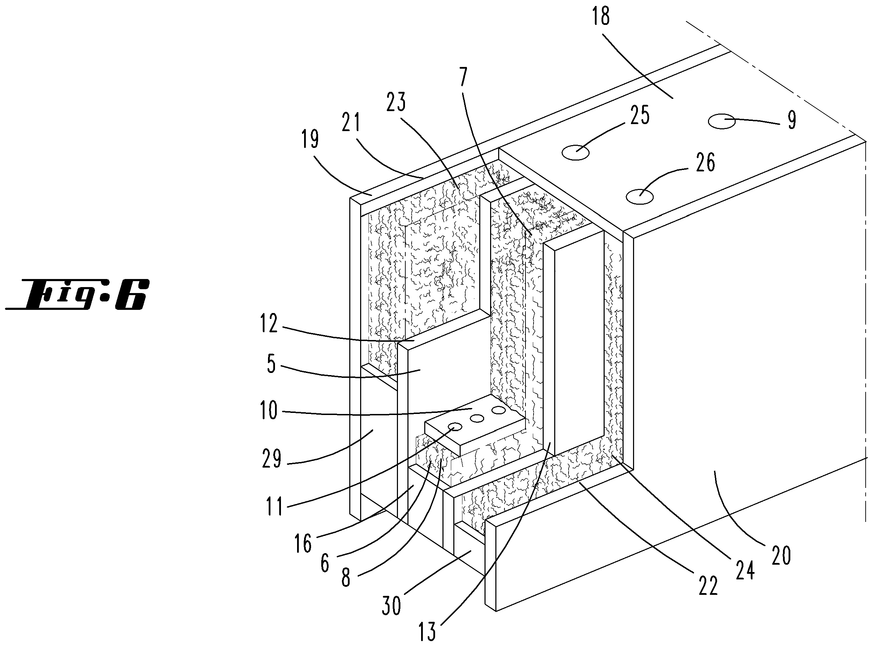

- Fig. 6: eine Darstellung eines Gaseinlassorganes in der Art eines Aufbruchs und
- Fig. 7: ein zweites Ausführungsbeispiel der Erfindung in einer Darstellung gemäß Figur 3.

In den Zeichnungen sind die wesentlichen Elemente einer PVD-Einrichtung dargestellt, um ein auf einem gekühlten Suszeptor 4 aufliegendes Substrat 1 mit einem organischen Material zu beschichten. Hierzu erstrecken sich zwei Gaseinlassorgane 2, 2' brückenartig über ein großflächiges Substrat 1. Das Substrat 1 wird in einer Bewegungsrichtung B relativ zu den beiden sich quer zur Bewegungsrichtung B erstreckenden Gaseinlassorganen 2,2' bewegt. Die Gaseinlassorgane 2, 2' sind parallel zueinander in Bewegungsrichtung B voneinander beabstandet.

Das Gaseinlassorgan 2 beziehungsweise 2' besitzt ein langgestrecktes Gehäuse, welches zwei voneinander wegweisende Stirnseiten aufweist. Die Stirnseiten werden von den kleinen Seitenflächen des Gehäuses ausgebildet, die diesseits und jenseits des Substrates 1 liegen.

Die zur zu beschichtenden Oberfläche des Substrates 1 weisende Seite des Gaseinlassorganes 2 bildet drei linienförmig nebeneinanderliegende Gasaustrittszonen 14, 27, 28 aus. Die Gasaustrittszonen 14, 27, 28 erstrecken sich quer zur Bewegungsrichtung B über die gesamte Breite des Substrates 1. Aus der mittleren Gasaustrittszone 14 strömt ein erster Gasstrom a, der einen von einem inerten Trägergasstrom transportierten Dampf eines organischen Ausgangsstoffs beinhaltet. Dieser erste Gasstrom a wird von einem zweiten Gasstrom b und von einem dritten Gasstrom c flankiert. Der zweite Gasstrom b und der dritte Gasstrom c wird von einem beheizten Inertgasstrom ausgebildet. Die Gasaustrittszonen 27, 28, durch die die flankierenden Gasströme b, c austreten, sind der mittleren Gasaustrittszone 14 unmittelbar benachbart. Die Gasaustrittszonen 27, 14 beziehungsweise 28, 14 sind nur durch eine dünne Trennwand 12, 13 voneinander getrennt, die aus einem isolierenden Werkstoff, beispielsweise einem keramischen Material (Cogebi), bestehen.

Die Gasaustrittszonen 14, 27, 28 werden von den Oberflächen von elektrisch leitenden Schaumkörpern 23, 24, 8 ausgebildet. Die Schaumkörper 23, 24, 8 liegen in von dem Gehäuse des Gaseinlassorgans 2 gebildeten Kammern 6, 21, 22 ein. Die offenporigen Schaumkörper 23, 8, 24 füllen die ihnen zugeordneten Gasverteilkammern 21, 6, 22 voll aus. Während die beiden den flankierenden zweiten und dritten Gasaustrittszonen 27, 28 zugeordneten Gasverteilkammern 21, 22 jeweils von einer Außenwand 19, 20 und einer Trennwand 12, 12', jeweils aus einem elektrisch isolierenden Werkstoff, begrenzt sind, ist eine aus zwei Abschnitten 5, 6 bestehende erste Gasverteilkammer 6 von den beiden Trennwänden 12, 13 begrenzt. Als Gasaustrittszonen 14, 27, 28 steht die gesamte Breite der Gasverteilkammern 21, 6, 22 zur Verfügung.

Das Gehäuse des Gaseinlassorgans 2 besitzt eine obere Wandung 18, die ebenfalls aus einem elektrisch isolierenden Werkstoff gefertigt ist. Durch diese obere Wandung 18 erfolgt eine Gaseinspeisung in die Gasverteilkammern 5, 21, 22. Ein stromaufwärtiger Abschnitt 5 der ersten Gasverteilkammer, die vollständig mit einem Schaumkörper 7 ausgefüllt ist, wird durch eine Zuleitung 9 mit einem Aerosol gespeist. Das Aerosol wird in einem Aerosolerzeuger 31 erzeugt. Dieser besitzt ein Pulverreservoir oder ein Flüssigkeitsreservoir und einen Injektor, mit dem das Pulver oder mit dem Tröpfchen der Flüssigkeit in einen Trägergasstrom injiziert werden. Mit dem Trägergasstrom werden die festen oder flüssigen Partikel des organischen Ausgangsstoffs in den Schaumkörper 7 des oberen Abschnittes 5 der Gasverteilkammer eingespeist. Die Einspeisung des Aerosols erfolgt durch die der Gasaustrittszone 14 gegenüberliegenden Öffnungen in der oberen Wandung 18.

In der oberen Wand 18 sind Gaseintrittsöffnungen 25, 26 vorgesehen, durch die ein Inertgas in die Gasverteilkammern 21, 22 beziehungsweise die darin angeordneten Schaumkörper 23, 24 eingespeist wird. Die Gaseintrittsöffnungen 25, 26 sind mit Zuleitungen 32, 33 für das Inertgas verbunden.

Die Schaumkörper 7, 8, 23, 24 können mittels elektrischer Energie beheizt werden. Hierzu weist jede der Gasverteilkammern 21, 22 beziehungsweise 5, 6 an ihren sich gegenüberliegenden Stirnseiten Elektroden 15, 16, 29, 30 auf, die von einer Verschlussplatte 17 gehalten werden. Die Elektroden 15, 16, 29, 30 sind durch die Trennwände 12, 13 elektrisch voneinander isoliert.

Die mittlere, erste Gasverteilkammern ist in zwei Abschnitte 5, 6 aufgeteilt. In jedem der beiden Abschnitte 5, 6 befindet sich ein Schaumkörper 7, 8. Die Abschnitte 5, 6 liegen in Strömungsrichtung hintereinander und bevorzugt vertikal übereinander. Der gaseintrittsseitige Abschnitt 5 bildet eine Verdampfungskammer. Der darin angeordnete Schaumkörper 7 bildet eine Verdampfungseinrichtung, mit der das durch die Zuleitung 9 in den gaseintrittsseitigen Abschnitt 5 eingespeiste Aerosol verdampft wird.

Der gasaustrittsseitige Abschnitt 6 ist vom gaseintrittsseitigen Abschnitt 5 durch eine aus einem elektrisch isolierenden Werkstoff gefertigte Trennplatte 10 getrennt. Die Trennplatte 10 bildet eine Strömungsbegrenzungseinrichtung, da sie der Strömung einen Widerstand entgegensetzt. Es kann sich um eine Diffusorplatte handeln. Die Trennplatte 10 besitzt Öffnungen 11, durch die der verdampfte gasförmige Ausgangsstoff zusammen mit dem Trägergas von dem gaseintrittsseitigen Abschnitt 5 in den gasaustrittsseitigen Abschnitt 6 strömen kann.

Der Schaumkörper 8, der sich im gasaustrittsseitigen Abschnitt 6 befindet, und der die Gasaustrittsöffnung 14 ausbildet, kann separat gegenüber dem Schaumkörper 7, der im gaseintrittsseitigen Abschnitt 5 angeordnet ist, beheizt werden. Es können auch nicht dargestellte Mittel vorgesehen sein, um diesen gasaustrittsseitigen Schaumkörper 8 zu kühlen, so dass durch die Öffnung 10 dort hineintretender gasförmiger Ausgangsstoff dort kondensiert. Durch eine Variation der Temperatur des gasaustrittsseitigen Schaumkörpers 8 kann somit der Materialfluss des Ausgangsstoffes im Gasstrom a variiert werden. Es ist auch ein Ein- oder Ausschalten möglich.

Während des Beschichtungsschrittes tritt aus der mittleren Gasaustrittsöffnung 15 ein gasförmiger organischer Ausgangsstrom a mit einer Temperatur, die oberhalb der Verdampfungstemperatur des Ausgangsstoffes liegt, aus. Die den mittleren Gasstrom flankierenden randseitigen Gasströme b, c besitzen im Wesentlichen dieselbe Temperatur wie der mittlere Gasstrom a, so dass sie eine Isolationsfunktion ausüben. Indem die randseitigen Gasströme b, c den mittleren Gasstrom a unmittelbar benachbart sind, zwingen sie dem mittleren Gasstrom a eine lineare Bewegungsrichtung auf. Eine Divergenz des aus dem Gaseinlassorgan 2 austretenden linienförmigen Gasstromes a, b, c findet somit lediglich in den äußeren Bereichen der randseitigen Gasströme b, c statt.

Die Elektroden 15, 16, 29, 30 können mit Schrauben am Schaumkörper 7, 8, 23, 24 befestigt sein. Die Schaumkörper 7, 8, 23, 24 werden über die gesamte Länge des Gaseinlassorganes 2 voneinander durch isolierende Wände 12, 13, 19, 20, 18 voneinander und von der Umgebung getrennt.

Das Aerosol enthält feste oder flüssige Partikel mit einem mittleren Durchmesser im Mikrometerbereich. Die Partikel haben bevorzugt eine im Wesentlichen einheitliche Größe. Die Temperatur der hitzebeständigen Schaumkörper 7, 8, 23, 24 werden mittels Temperatur-Messeinrichtungen, beispielsweise Thermoelementen, gemessen. Es findet eine Temperaturregelung statt. Hierzu sind geschlossene Regelkreise vorgesehen.

Die Trennplatte 10 ist eine Diffusorplatte, die eine Mehrzahl von insbesondere gleichmäßig beabstandeten Öffnungen 11 aufweist, so dass damit eine Homogenisierung des Gasstroms erfolgt. Durch die oben erwähnte Kondensation des organischen Ausgangsstoffs an den Zellwänden des Schaumkörpers 8 im gasaustrittsseitigen Abschnitt 6 der Gasverteilkammer kann eine stabilisierte Dampfeinspeisung in die Prozesskammer 3 zwischen Gasaustrittsöffnung 14 und Oberfläche des Substrates 1 gewährleistet werden.

Die den mittleren Gasstrom a flankierenden randseitigen Gasströme b, c verhindern, dass sich im Bereich des mittleren Gasstroms a Turbulenzen ausbilden. Sie verhindern darüber hinaus, dass von anderen Gaseinlassorganen in die Prozesskammer eingespeiste andere organische Ausgangsstoffe in den mittleren Gasstrom a gelangen können. Es ist somit möglich, dass mehrere Gaseinlassorgane 2, 2' in derselben Prozesskammer 3 in Bewegungsrichtung B des Substrates 1 hintereinanderliegend angeordnet werden können, mit denen voneinander verschiedene organische Ausgangsstoffe zur Oberfläche des Substrates 1 gebracht werden, wo sie durch Kondensation eine Schicht bilden.

Das Aerosol kann aus dem Aerosolerzeuger 31, der auch eine Aerosol-Dosiervorrichtung aufweisen kann, mittels Stickstoff in die Gasverteilkammer 5 gefördert werden. In die die mittleren Gasverteilkammern 5, 6 flankierenden äußeren Gasverteilkammern 21, 22 kann ebenfalls Stickstoff eingespeist werden. Die Gasflüsse sind so bemessen, dass aus den Gasaustrittszonen 27, 14, 28 ein homogener Gasstrom ausströmt. Die mittlere Gasaustrittsgeschwindigkeit aus den Gasaustrittszonen 14, 27, 28 ist bevorzugt dieselbe.

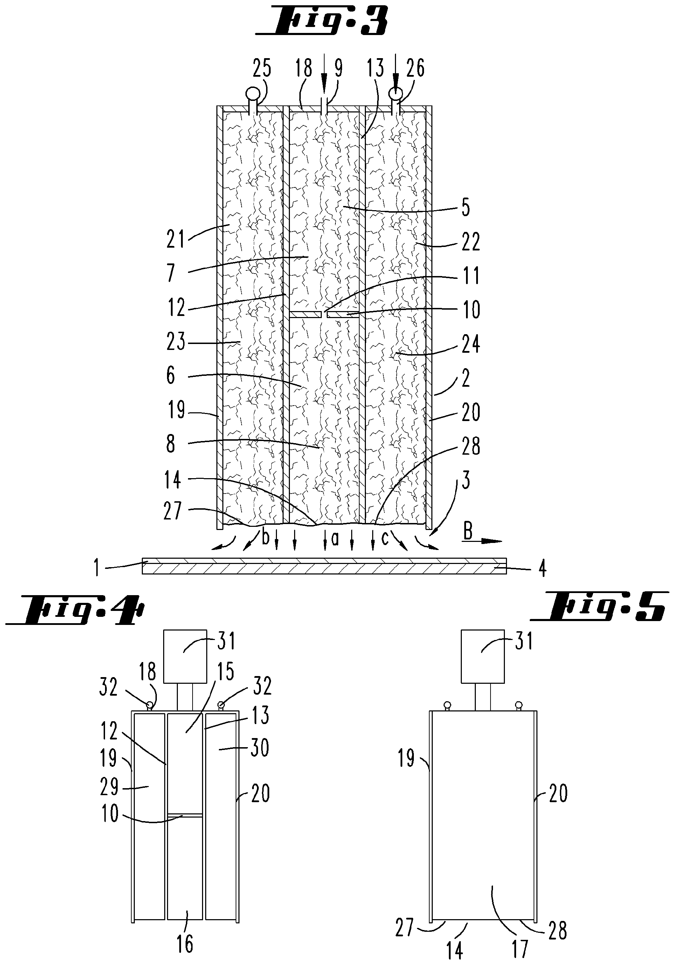

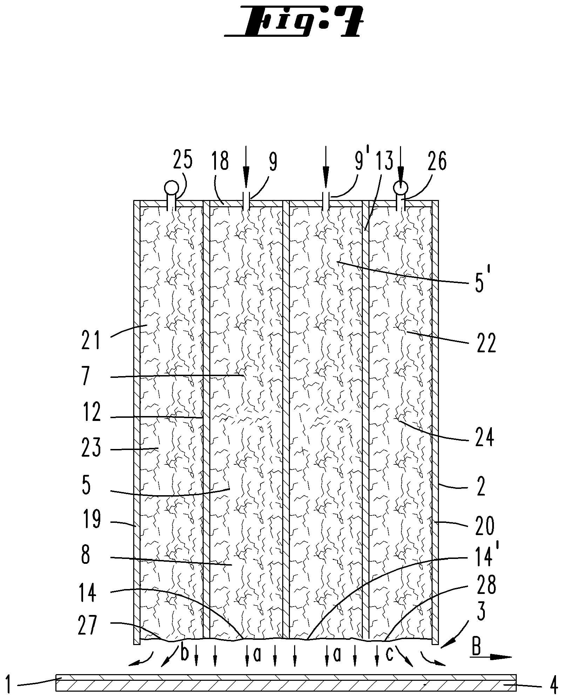

Die Figur 7 zeigt in einer Darstellung gemäß Figur 3 ein zweites Ausführungsbeispiel der Erfindung. Es sind zwei Prozessgas-Verteilkammern 5, 5' vorgesehen. Bei diesem Ausführungsbeispiel sind die beiden Prozessgas-Verteilkammern 5, 5' nicht durch eine Trennplatte in jeweils zwei Abschnitte geteilt. Es ist allerdings bevorzugt auch hier vorgesehen, dass sich die an die Prozessgas-Austrittszonen 14, 14' angrenzenden Abschnitte der Prozessgas-Verteilkammern 5, 5' auf eine Temperatur temperieren lassen, die unterhalb der Kondensationstemperatur des Dampfes liegt. In diesem Fall tritt aus den nebeneinander verlaufenden Prozessgas-Austrittszonen 14, 14' jeweils lediglich das Trägergas aus, mit dem der Aerosolstrom in die Einspeiseöffnung 9, 9' eingespeist wird. Werden hingegen beide Prozessgas-Verteilkammern 5, 5' in ihrem gesamten Volumen auf eine Temperatur aufgeheizt, die oberhalb der Verdampfungstemperatur des in die Einspeiseöffnungen 9, 9' eingespeisten organischen Materials liegt, so tritt aus den unmittelbar nebeneinander liegenden Prozessgas-Austrittszonen 14, 14' jeweils ein Prozessgasstrom a, a' heraus. Die beiden Prozessgas-Verteilkammern 5, 5' grenzen unmittelbar aneinander. Sie sind lediglich durch eine elektrisch nicht leitende Trennwand voneinander getrennt. Die Verdampfungseinrichtungen 7 innerhalb der Prozessgas-Verteilkammern 5, 5' können auf voneinander verschiedenen Temperaturen aufgeheizt werden. Insbesondere die Abschnitte der Verdampfungseinrichtungen, die unmittelbar an die Prozessgas-Austrittszonen 14, 14' angrenzen, lassen sich auf voneinander verschiedene Temperaturen bringen, so dass es möglich ist, durch beide Gasaustrittszonen 14, 14' Prozessgase austreten zu lassen oder jeweils nur aus einer der beiden Prozessgas-Austrittszonen 14, 14'.

Die beiden Prozessgasströme a, a' sind von Temperiergasströmen b, c flankiert, die aus separat beheizbaren Gasverteilkammern 21, 22 austreten.

Die vorstehenden Ausführungen dienen der Erläuterung der von der Anmeldung insgesamt erfassten Erfindungen, die den Stand der Technik zumindest durch die folgenden Merkmalskombinationen jeweils auch eigenständig weiterbilden, nämlich:
Eine Vorrichtung, die dadurch gekennzeichnet ist, dass die Gasheizeinrichtungen von in den Gasverteilkammern 5, 6, 5', 6'; 21, 22, die durch elektrisch isolierende Trennwände 12, 13 voneinander getrennt sind, angeordneten, elektrisch leitfähigen offenporigen Festkörpern gebildet sind, die durch elektrische Energie beheizbar sind, wobei zumindest ein gaseintrittsseitiger Abschnitt (5) des in der Prozessgas-Verteilkammer 5, 6; 5', 6' angeordneter offenporiger Festkörper eine Verdampfungseinrichtung 7 für einen durch die Einspeiseöffnung 9 einspeisbaren festen oder flüssigen Ausgangsstoff ausbildet.

Eine Vorrichtung, die dadurch gekennzeichnet ist, dass die Gasheizeinrichtungen von elektrisch leitfähigen offenporigen Festkörpern, insbesondere Schaumkörpern 7, 8, 23, 24 ausgebildet sind.

Eine Vorrichtung, die dadurch gekennzeichnet ist, dass die Schaumkörper 7, 8, 23, 24 die ihnen zugeordneten Gasverteilkammern 5, 6, 21, 22 vollständig ausfüllen.

Eine Vorrichtung, die dadurch gekennzeichnet ist, dass jeder Gasheizeinrichtung 7, 8, 23, 24 zwei Elektroden 15, 16, 29, 30 zugeordnet sind, wobei die Elektroden 15, 16, 29, 30 insbesondere an den sich gegenüberliegenden Stirnseiten des Gaseinlassorgans 2 angeordnet sind.

Eine Vorrichtung, die dadurch gekennzeichnet ist, dass die erste Prozessgas-Verteilkammer 5, 6 durch eine Strömungsbegrenzungseinrichtung 10 in einen stromaufwärtigen Abschnitt 5 und in einen stromabwärtigen Abschnitt 6 unterteilt ist.
Eine Vorrichtung, die dadurch gekennzeichnet ist, dass die Strömungsbegrenzungseinrichtung 10 eine Platte ist, die Öffnungen 11 aufweist.
Eine Vorrichtung, die dadurch gekennzeichnet ist, dass mindestens zwei Prozessgas-Verteilkammern 5, 6; 5', 6' nebeneinander angeordnet sind und stromaufwärts der mindestens beiden Prozessgas-Austrittszonen (14, 14') der Prozessgas-Verteilkammern (5, 6; 5', 6') die zweite Gasaustrittszone (22) und stromabwärts die dritte Gasaustrittszone (28) angeordnet sind.
Eine Vorrichtung, die dadurch gekennzeichnet ist, dass mehrere, im Wesentlichen gleich gestaltete Gaseinlassorgane 2, 2' in Bewegungsrichtung B des Substrates 1 hintereinanderliegend sich linienartig quer über die Bewegungsbahn des Substrates 1 erstrecken.
Eine Vorrichtung, die dadurch gekennzeichnet ist, dass die Gasaustrittsöffnungen 14, 27, 28 von den Oberflächen der porösen Festkörper 8, 23, 24 gebildet sind.

**Bezugszeichenliste:**

| | | | |
|---|---|---|---|
| 1 | Substrat | 23 | Schaumkörper |
| 2 | Gaseinlassorgan | 24 | Schaumkörper |
| 2' | Gaseinlassorgan | 25 | Gaseintrittsöffnung |
| 3 | Prozesskammer | 26 | Gaseintrittsöffnung |
| 4 | Suszeptor | 27 | Gasaustrittszone |
| 5, 5' | Prozessgasverteilkammer, stromaufwärtiger Abschnitt | 28 | Gasaustrittszone |
| 6, 6' | Prozessgasverteilkammer, stromabwärtiger Abschnitt | 29 | Elektrode |
| 7 | Verdampfungseinrichtung, Schaumkörper | 30 | Elektrode |
| 8 | Schaumkörper | 31 | Aerosolerzeuger |
| 9, 9' | Einspeiseöffnung, Zuleitung | 32 | Zuleitung |
| 10 | Strömungsbegrenzungsplatte, Trennplatte | 33 | Zuleitung |
| 11 | Öffnung | | |
| 12 | Trennwand | | |
| 12' | Trennwand | B | Bewegungsrichtung |
| 13 | Trennwand | | |
| 14, | Prozessgas-Austrittszone, Prozessgas- | a | Prozessgasstrom |
| 14' | Austrittsöffnung | | |
| 15 | Elektrode | a' | Prozessgasstrom |
| 16 | Elektrode | b | Temperiergasstrom |
| 17 | Verschlussplatte | c | Temperiergasstrom |
| 18 | obere Wandung | | |
| 19 | Wand | | |
| 20 | Wand | | |
| 21 | Gasverteilkammer | | |
| 22 | Gasverteilkammer | | |

## Patentansprüche

1. Vorrichtung zum Abscheiden einer Schicht auf einem Substrat (1), das beim Beschichten quer zur Erstreckungsrichtung eines Gaseinlassorgans (2) in einer Prozesskammer (3) in einer Bewegungsrichtung (B) bewegt wird, wobei das Gaseinlassorgan (2) mindestens eine Prozessgas-Verteilkammer (5, 6; 5', 6') aufweist mit einer Einspeiseöffnung (9, 9') zum Einspeisen mindestens eines Ausgangsstoffs und einer sich über die gesamte Breite der Bewegungsbahn des Substrates (1) erstreckenden, zum Substrat (1) weisenden Prozessgas-Austrittszone (14, 14') zum Austritt eines Prozessgasstroms (a, a'), das den Ausgangsstoff beinhaltet, wobei parallel zur Erstreckungsrichtung der ersten Gasaustrittszone (14) in Bewegungsrichtung (B) des Substrates (1) vor der mindestens einen Prozessgas-Austrittszone (14) eine zweite Gasaustrittszone (27) und in Bewegungsrichtung (B) des Substrates (1) nach der mindestens einen Prozessgas-Austrittszone (14) eine dritte Gasaustrittszone (28), jeweils einer zweiten beziehungsweise dritten Gasverteilkammer (21, 22) angeordnet sind zum Austritt jeweils eines zweiten beziehungsweise dritten Gasstroms (b, c), wobei die zweite und dritte Gasaustrittszone (27, 28) der mindestens einen Prozessgas-Austrittszone (14) unmittelbar benachbart angeordnet sind, und Gasheizeinrichtungen besitzen, **dadurch gekennzeichnet, dass** die Gasheizeinrichtungen von in den Gasverteilkammern (5, 6, 5', 6'; 21, 22), die durch elektrisch isolierende Trennwände (12, 13) voneinander getrennt sind, angeordneten, elektrisch leitfähigen offenporigen Festkörpern gebildet sind, die durch elektrische Energie beheizbar sind, wobei zumindest ein gaseintrittsseitiger Abschnitt (5) des in der Prozessgas-Verteilkammer (5, 6; 5', 6') angeordneter offenporiger Festkörper eine Verdampfungseinrichtung (7) für einen durch die Einspeiseöffnung (9) einspeisbaren festen oder flüssigen Ausgangsstoff ausbildet.

2. Vorrichtung nach Anspruch 1, **dadurch gekennzeichnet, dass** die Gasheizeinrichtungen von Schaumkörpern (7, 8, 23, 24) ausgebildet sind.

3. Vorrichtung nach Anspruch 2, **dadurch gekennzeichnet, dass** die Schaumkörper (7, 8, 23, 24) die ihnen zugeordneten Gasverteilkammern (5, 6, 21, 22) vollständig ausfüllen.

4. Vorrichtung nach einem der vorhergehenden Ansprüche, **dadurch gekennzeichnet, dass** jeder Gasheizeinrichtung (7, 8, 23, 24) zwei Elektroden (15, 16, 29, 30) zugeordnet sind.

5. Vorrichtung nach Anspruch 4, **dadurch gekennzeichnet, dass** die Elektroden (15, 16, 29, 30) an den sich gegenüberliegenden Stirnseiten des Gaseinlassorgans (2) angeordnet sind.

6. Vorrichtung nach einem der vorhergehenden Ansprüche, **dadurch gekennzeichnet, dass** die erste Prozessgas-Verteilkammer (5, 6) durch eine Strömungsbegrenzungseinrichtung (10) in einen stromaufwärtigen Abschnitt (5) und in einen stromabwärtigen Abschnitt (6) unterteilt ist.

7. Vorrichtung nach Anspruch 6, **dadurch gekennzeichnet, dass** die Strömungsbegrenzungseinrichtung (10) eine Platte ist, die Öffnungen (11) aufweist.

8. Vorrichtung nach einem der vorhergehenden Ansprüche, **dadurch gekennzeichnet, dass** mindestens zwei Prozessgas-Verteilkammern (5, 6; 5', 6') nebeneinander angeordnet sind und stromaufwärts der mindestens beiden Prozessgas-Austrittszonen (14, 14') der Prozessgas-Verteilkammern (5, 6; 5', 6') die zweite Gasaustrittszone (22) und stromabwärts die dritte Gasaustrittszone (28) angeordnet sind.

9. Vorrichtung nach einem der vorhergehenden Ansprüche, **dadurch gekennzeichnet, dass** mehrere Gaseinlassorgane (2, 2') in Bewegungsrichtung (B) des Substrates (1) hintereinanderliegend sich linienartig quer über die Bewegungsbahn des Substrates (1) erstrecken.

10. Vorrichtung nach einem der vorhergehenden Ansprüche, **dadurch gekennzeichnet, dass** die Gaseinlassorgane (2, 2') im Wesentlichen gleichgestaltet sind.

11. Vorrichtung nach einem der vorhergehenden Ansprüche, **dadurch gekennzeichnet, dass** die Gasaustrittsöffnungen (14, 27, 28) von den Oberflächen der porösen Festkörper (8, 23, 24) gebildet sind.

## Claims

1. A device for depositing a layer on a substrate (1), which is moved in a moving direction (B) in a process chamber (3) transverse to the direction of extent of a gas inlet element (2) during the coating process, wherein the gas inlet element (2) features at least one process gas distribution chamber (5, 6; 5', 6') with an infeed opening (9, 9') for feeding in at least one starting material and with a process gas outlet zone (14,14'), which extends over the entire width of the moving path of the substrate (1) and points toward the substrate (1), for the outflow of a process gas flow (a, a') containing the starting material, wherein, parallel to the direction of extent of the first gas outlet zone (14), a second gas outlet zone (27) of a second gas distribution chamber (21) is arranged in front of the at least one process gas outlet zone (14) referred to the moving direction (B) of the substrate (1) for the outflow of a second gas flow (b) and a third gas outlet zone (28) of a third gas distribution chamber (22) is arranged behind the at least one process gas outlet zone (14) referred to the moving direction (B) of the substrate (1) for the outflow of a third gas flow (c), and wherein the second and third gas outlet zones (27, 28) are arranged directly adjacent to the at least one process gas outlet zone (14) and feature gas heating apparatuses, **characterized in that** the gas heating apparatuses are formed by electrically conductive, open-pored solid bodies that can be heated by means of electrical energy and are arranged in the gas distribution chambers (5, 6, 5', 6'; 21, 22), which are separated from one another by electrically insulating partition walls (12, 13), wherein at least a section (5) of the open-pored solid body arranged in the process gas distribution chamber(5, 6; 5', 6') on the gas inlet side forms an evaporation apparatus (7) for a solid or liquid starting material that can be fed in through the infeed opening (9).

2. The device according to claim 1, **characterized in that** the gas heating apparatuses are formed by foam bodies (7, 8, 23, 24).

3. The device according to claim 2, **characterized in that** the foam bodies (7, 8, 23, 24) completely occupy the gas distribution chambers (5, 6, 21, 22) assigned thereto.

4. The device according to one of the preceding claims, **characterized in that** two electrodes (15, 16, 29, 30) are assigned to each gas heating apparatus (7,8,23,24).

5. The device according to claim 4, **characterized in that** the electrodes (15, 16, 29, 30) are arranged on the opposite end faces of the gas inlet element (2).

6. The device according to one of the preceding claims, **characterized in that** the first process gas distribution chamber (5, 6) is divided into an upstream section (5) and a downstream section (6) by means of a flow restriction device (10).

7. The device according to claim 6, **characterized in that** the flow restriction device (10) is a plate with openings (11).

8. The device according to one of the preceding claims, **characterized in that** at least two process gas distribution chambers (5, 6; 5', 6') are arranged adjacent to one another, wherein the second gas outlet zone (22) is arranged upstream and the third gas outlet zone (28) is arranged downstream of the at least two process gas outlet zones (14, 14') of the process gas distribution chambers (5, 6; 5', 6').

9. The device according to one of the preceding claims, **characterized in that** multiple gas inlet elements (2, 2') are arranged behind one another referred to the moving direction (B) of the substrate (1) such that they linearly and transversely extend over the moving path of the substrate (1).

10. The device according to one of the preceding claims, **characterized in that** the gas inlet elements (2, 2') are essentially designed identically.

11. The device according to one of the preceding claims, **characterized in that** the gas outlet openings (14, 27, 28) are formed by the surfaces of the porous solid bodies (8, 23, 24).

## Revendications

1. Dispositif de dépôt d'une couche sur un substrat (1) qui est déplacé lors du revêtement dans une direction de déplacement (B) dans une chambre de traitement (3) transversalement à la direction d'extension d'un élément d'entrée de gaz (2), l'élément d'entrée de gaz (2) comportant au moins une chambre de distribution de gaz de traitement (5, 6 ; 5', 6') qui est pourvue d'un orifice d'introduction (9, 9'), destiné à introduire au moins une matière de départ, et d'une zone de sortie de gaz de traitement (14, 14') s'étendant sur toute la largeur du trajet de déplacement du substrat (1), dirigée vers le substrat (1) et destinée à la sortie d'un flux de gaz de traitement (a, a') contenant la matière de départ, une deuxième zone de sortie de gaz (27) et une troisième zone de sortie de gaz (28), respectivement d'une deuxième et d'une troisième chambre de distribution de gaz (21, 22) destinées respectivement à la sortie d'un deuxième et d'un troisième flux de gaz (b, c), étant disposées respectivement en amont de l'au moins une zone de sortie de gaz de traitement (14) dans la direction de déplacement (B) du substrat (1) parallèlement à la direction d'extension de la première zone de sortie de gaz (14) et en aval de l'au moins une zone de sortie de gaz de traitement (14) dans la direction de déplacement (B) du substrat (1), les deuxième et troisièmes zone de sortie de gaz (27, 28) de l'au moins une zone de sortie de gaz de traitement (14) étant disposées de manière immédiatement adjacentes et comportant des moyens de chauffage de gaz, **caractérisé en ce que** les moyens de chauffage de gaz sont formés par des corps solides à pores ouverts, électriquement conducteurs, qui sont disposés dans les chambres de distribution de gaz (5, 6, 5', 6' ; 21, 22), séparées les unes des autres par des cloisons électriquement isolantes 12, 13), et qui peuvent être chauffés par de l'énergie électrique, au moins une partie (5), côté entrée de gaz, des corps solides à pores ouverts, disposé dans la chambre de distribution de gaz de traitement (5, 6 ; 5', 6'), formant un moyen d'évaporation (7) destiné à une matière solide ou liquide pouvant être introduite par l'orifice d'introduction (9).

2. Dispositif selon la revendication 1, **caractérisé en ce que** les moyens de chauffage de gaz sont formés par des corps en mousse (7, 8, 23, 24).

3. Dispositif selon la revendication 2, **caractérisé en ce que** les corps en mousse (7, 8, 23, 24) remplissent totalement les chambres de distribution de gaz (5, 6, 21, 22) qui leur sont associées.

4. Dispositif selon l'une des revendications précédentes, **caractérisé en ce que** deux électrodes (15, 16, 29, 30) sont associées à chaque moyen de chauffage de gaz (7, 8, 23, 24).

5. Dispositif selon la revendication 4, **caractérisé en ce que** les électrodes (15, 16, 29, 30) sont disposées au niveau des faces d'extrémité opposées de l'élément d'entrée de gaz (2) .

6. Dispositif selon l'une des revendications précédentes, **caractérisé en ce que** la première chambre de distribution de gaz de traitement (5, 6) est divisée par un moyen de limitation d'écoulement (10) en une partie amont (5) et une partie aval (6).

7. Dispositif selon la revendication 6, **caractérisé en ce que** le moyen de limitation d'écoulement (10) est une plaque pourvue d'ouvertures (11).

8. Dispositif selon l'une des revendications précédentes, **caractérisé en ce qu'**au moins deux chambres de distribution de gaz de traitement (5, 6 ; 5', 6') sont disposés côte à côte et la deuxième zone de sortie de gaz (22) et la troisième zone de sortie de gaz (28) sont disposées respectivement en amont et en aval des au moins deux zones de sortie de gaz de traitement (14, 14') des chambres de distribution de gaz de traitement (5, 6 ; 5', 6').

9. Dispositif selon l'une des revendications précédentes, **caractérisé en ce que** plusieurs éléments d'entrée de gaz (2, 2') s'étendent les uns derrière les autres dans la direction de déplacement (B) du substrat (1) linéairement et transversalement au trajet de déplacement du substrat (1).

10. Dispositif selon l'une des revendications précédentes, **caractérisé en ce que** les éléments d'entrée de gaz (2, 2') sont sensiblement identiques.

11. Dispositif selon l'une des revendications précédentes, **caractérisé en ce que** les orifices de sortie de gaz (14, 27, 28) sont formés par des surfaces des corps solides poreux (8, 23, 24).
